# EUROPEAN PATENT SPECIFICATION

(11) **EP 2 660 878 B1**
(45) Date of publication and mention of the grant of the patent: **31.12.2014**
(21) Application number: 12166772.9
(22) Date of filing: 04.05.2012
(51) Int. Cl.: H01L 31/05

(54) **Hybrid woven materials useful in the production of back-contact solar cells.**
Hybride Webmaterialien zur Herstellung von Solarzellen mit hinterem Kontakt
Matières tissées hybrides utiles dans la production de cellules solaires à contact arrière

(43) Date of publication of application: 06.11.2013
(73) Proprietor: Sol Invictus Energy, 7181 Seneffe (BE)
(72) Inventor: Borgers, Tom, 3000 Leuven (BE)
(74) Representative: Pecher, Nicolas

(56) References cited:
- WO-A1-2010/025269
- WO-A1-2012/026046
- DE-A1-102010 013 850
- US-A1- 2004 244 193
- US-A1- 2009 032 087
- US-A1- 2012 103 415

## Description

### Field of the invention

The present invention is related to hybrid woven materials useful in the production of photovoltaic devices such as solar cells and solar panels. More particularly it relates to means for connecting an ohmic contact to an external connector when the termination contact points to the two oppositely doped regions of the solar cells are placed on the non-illuminated surface of the solar cell.

### Technological background

Most solar cells described in the prior art can be subdivided into several categories according to their general structure.

The most common solar cells, the so-called standard cells, have their oppositely doped regions on both sides of the cell, and metallization including busbars on the illuminated side. There has long been a desire in the solar cell industry to get away with busbars on the illuminated side, as they create important shadowing losses.

In the so called back-contact solar cells, both ohmic contacts to the two oppositely doped regions of the solar cells (i.e. both series of external connecting points, also called termination points) are placed on the back or non-illuminated surface of the solar cell. A back contact solar cell thus provides termination point to the positive and negative terminals at the backside of the cell. This concept enables to reduce shadowing losses.

Back-contact solar cells fall into three main categories (for a review paper, see Prog. Photovolt: Res. Appl. 2006; 14:107-123).

Interdigitated Back-Contact (IBC) cells include those cell designs which rely upon carrier collection at a rear junction alone; they require silicon of high purity.

Emitter Wrap-Through (EWT) cells have carrier collection at both sides and rely upon current conduction from the front to the back through a large number of closely spaced through hole or via's in the cell.

Metal Wrap-Through (MWT) cells have a structure that is most closely linked to the standard cell structure. In these cells, the emitter is located on the illuminated side, the busbars moved to the rear surface, leaving only a thin front surface grid on the illuminated surface that is connected to the rear surface by extending it through a small number of metallised openings (or vias) in the wafer. WO 98/54763 discloses MWT cells.

In all types of back-contact cells, the current is collected at contact points or areas, which are then soldered to copper strips called connectors or interconnectors, at least one connector being soldered to a series of negative contact points or areas and at least one other being soldered to a series of positive contact points.

When the connector passes over an area of opposite sign, there must be placed an insulating layer between them. The practical result is that holes must be provided in the insulating layer; the holes must be made in the insulating layer and the insulating layer must be placed over the non-illuminated side in such a way that the holes face the contact points, thus allowing making the electrical connection e.g. by soldering. The making of the holes and the aligning of the insulating layer are two difficult operations. There is thus a need to find an easier connection system, avoiding the need to make holes in the insulating layer.

The inventors have already proposed in a co-pending application a connection system **characterised in that** the connectors are electrically connected to the contact points through a layer of insulating material separating the connectors from the non-illuminated surface, the connection embedding insulating material.

US-2004/0244193-A describes plain weave hybrid textile material, wherein the electrically conductive wire is sheathed with an insulation, the wire and its insulation are then severed and the wire is finally electrically connected as desired.

WO 2012/026046 A1 discloses a woven mesh substrate having a plurality of insulating wires being vertical threads and a plurality of conducting wires being horizontal threads, the mesh substrate embedding a plurality of spherical solar cells.

### Aim of the invention

It is an aim of the invention to provide hybrid woven materials useful in the production of photovoltaic devices.

It is an aim of this invention to provide a method for producing a back-contact photovoltaic cell, which alleviates or avoids some problems of the prior art.

It is an aim of this invention to provide a new concept for connecting series of contact points of the same polarity without using conventional copper strips.

Another aim of the invention is to provide a new concept for connecting series of contact points of the same polarity using only one component combining the electrical insulation and conduction functions.

It is a particular aim of this invention to provide a method for electrically connecting contact points of the same polarity using the conductive fibres of a woven sheet made of conductive fibres and insulating fibres.

It is a further aim of the invention to provide a method for producing a module comprising two or more interconnected back-contact photovoltaic cells.

### Summary of the invention

The invention provides hybrid woven material made of conductive wires interwoven with insulating wires using such a weaving pattern that the conductive wires remain spatially separated by insulating threads from a surface when the material is applied against said surface, useful in the manufacture of photovoltaic devices such as solar cells and panels.

In particular, the invention provides hybrid woven material made of conductive wires interwoven with insulating wires using the Leno weaving pattern wherein the filling threads are selected from conductive wires and a combination of conductive wires and insulating threads, and the warp threads are insulating threads, useful in the manufacture of photovoltaic devices such as solar cells and panels.

The invention provides a back-contact solar cell wherein the contact points to the two oppositely doped regions of the solar cells are placed on the non-illuminated surface of the solar cell, comprising connectors to collect the current from the contact points, **characterised in that** the connectors are conductive wires interwoven with insulating wires, the weaving pattern being such as to electrically insulate the conductive wires from the non-illuminated surface, the conductive wires being electrically connected to the contact points using a conductive junction embedding the insulating wires physically separating the conductive wires from the contact point, and each conductive wire connecting contact points of the same polarity on the cell.

The invention also provides a process for connecting ohmic contacts of a back-contact solar cell to external connectors, comprising the steps of:
- providing a solar cell wherein the contact points to the two oppositely doped regions are placed on its non-illuminated surface;
- providing a hybrid woven material made of conductive wires interwoven with insulating wires using such a weaving pattern that the conductive wires remain spatially separated by insulating threads from a surface when the material is applied against said surface;
- laying a layer of the hybrid woven material over the non-illuminated surface of the solar cell, the conductive wires being aligned with contact points of the same polarity, each contact point facing at least one conductive wire;
- electrically connecting each contact point to the conductive wires facing it, thereby embedding the insulating wires physically separating the conductive wires from the contact point into the connection.

The invention further provides for the serial assembly of at least two back-contact cells according to the invention, wherein the hybrid woven material extends over more than one cell, the contact points of one polarity of each cell being connected to the contact points of the opposite polarity of the next cell, the connecting wires being interrupted at appropriate locations between the cells in order to connect them in series.

The invention still further provides for the use in back-contact solar cells or panels of hybrid woven material made of conductive wires interwoven with insulating wires using such a weaving pattern that the conductive wires remain spatially separated by insulating threads from a surface when the material is applied against said surface. In particular, the invention provides for the use in back-contact solar cells or panels of hybrid Leno-woven material wherein the conductive wires are used as filling threads and the insulating wires as warp threads.

### Description of the figures

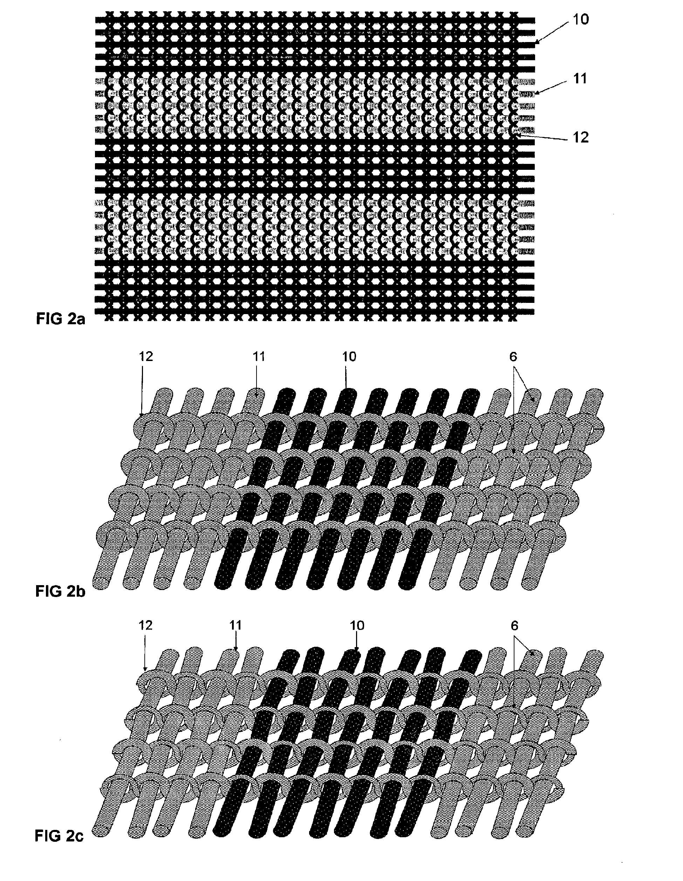

The Figures relate to MWT-type back-contact cells, which are particularly suitable for use with the invention; Fig. 2 onwards are only schematic, and the size of the elements has on purpose not been drawn to scale for illustrative purposes.
Fig 1a shows a top view of the back (non-illuminated) side of a MWT-type back-contact cell having six rows of contact points.
Fig 1b shows the same, indicating typical dimensions.
Fig 2a shows a top view of a hybrid Leno weave material.
Fig 2b shows a detail of a Leno weave material.
Fig 2c shows a detail of a Leno weave material made with warp threads of alternating diameters.
Fig 3a shows a detail of Fig. 1.
Fig 3b shows a cross section view through a contact point to the front surface grid on the illuminated surface (also described as cross-section of first section).
Fig 3c shows a cross-section view through a contact point to the back surface (also described as cross-section of second region).
Fig 4a 4b and 4c show the same views as respectively Fig 3a 3b and 3c after application of two drops of solder paste on each contact point, according to an embodiment of the invention.
Fig 5a 5b and 5c show the same views as respectively Fig 4a 4b and 4c after laying a layer of hybrid Leno weave material over the backside of the cell.
Fig 6a 6b and 6c show the same views as respectively Fig 5a 5b and 5c after soldering.
Fig 7 shows the back side of a finished cell when the conductive threads are oriented at 90° compared to Figures 3 to 6.
Fig 8a shows the connection between two cells, the current being collected by standard solderable connectors at each end.
Fig. 8b shows the connection between two cells, the current being collected via warp copper yarns at each end.
Fig. 8c shows the connection between two strings, each consisting of 2 cells, the string connection being provided by using warp conductive wires and holes.

In the figures, the following are represented:
**1:** first region (substrate)
**2:** second region
**3:** non solderable contact to second region **2**
**4:** external contact to first region **1**
**5:** solder paste
**6:** insulating fibre
**7:** ribbon (wire) connected to first region **1**
**8:** external contact to second region **2**
**9:** ribbon (wire) connected to second region **2**
**10:** conductive wires/strands/...
**11**: insulating filling threads
**12:** insulating warp threads.

### Detailed description of the invention

The invention is applicable to back-contact cells of all types, but particularly applicable to MWT cells and will thus be described with reference to such a cell. In this description, we will refer to the regions of opposite polarity as the first and the second region, the first region being on the illuminated side and the second on the back (non-illuminated) side.

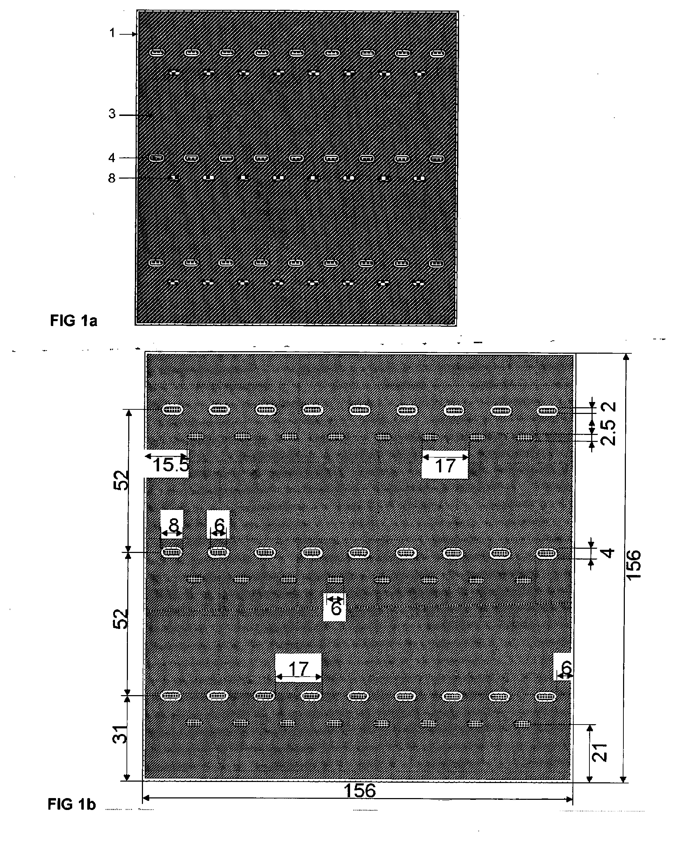

As shown on Fig. 1, the back side of the cell comprises on most of the surface of the wafer **1** an area **3,** consisting of a metallic coating usually a non-solderable aluminium coating, and six rows of contact areas also called contact points having a rectangular shape with rounded ends. From the top of Fig 1, the first, third and fifth rows are shown to comprise nine solderable contact points **4** to the first region, connected through one or more via's to the first region on the front (illuminated) side and surrounded by a groove in order to be electrically insulated from the second region which is at the interface between the substrate **1** and the metallic layer **3.** The second, fourth and sixth rows are shown to comprise eight solderable contact points **8** to the second region.

Fig. 2a shows a hybrid Leno weave material made of conductive wires interwoven with insulating wires using the Leno weaving pattern, wherein the filling threads are selected from a combination of conductive wires and insulating threads, a series of conductive wires **10** (typically made of tinned copper) alternating with a series of insulating threads **11** and the warp threads **12** are insulating threads. Insulating threads are typically made of glass fibres, although polymer fibres can also be used.

The Leno weave is **characterised in that** each couple of warp threads **12** is twisted between each filling thread **10,** thus keeping the filling threads **10** spatially separated and in an essentially linear position.

In another embodiment (shown in Fig 2c), there are preferably used alternating insulating threads of different diameter. In each couple of warp threads **12,** one has a larger diameter. This is an embodiment that brings some advantages when using the material of the invention in the construction of solar cells: this imparts some elasticity to Leno-weave material, allowing compensating for thermal expansion differences between cell material and conductive wires.

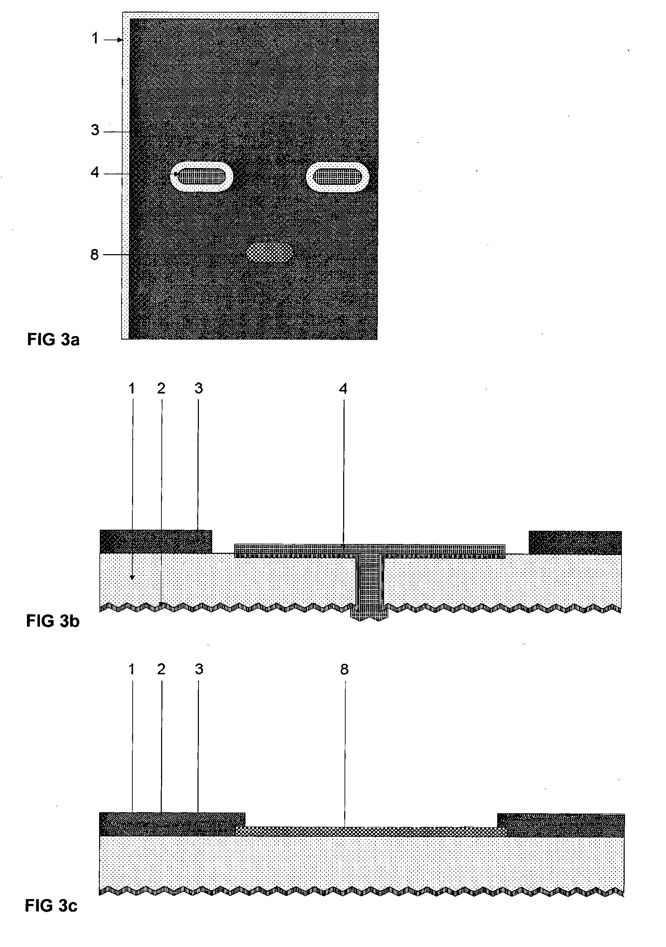

Fig 3a shows a top view of a small portion of the back (non-illuminated) side of a MWT-type back-contact cell with two contact points to the front surface grid and one contact point to the back surface.

Fig 3b shows a cross section view through a contact point **4** linked through one via to the first region on the illuminated surface **2.** The contact point **4** is electrically insulated from the second region by a groove (not shown). Each contact point **4** could also be connected to the first region by means of more than one via.

Fig 3c shows a cross-section view through a contact point **8** to the second region. The contact point **8** is usually a layer of solderable material deposited on the second region, being surrounded by area **3.**

Electrically connecting each contact point to the conductive wires facing it can be done by soldering (using a solder paste) or heat curing (using a conductive adhesive or an anisotropic paste).

The process for connecting the ohmic contacts starts with the application of solder paste on each contact point.

According to another embodiment of the invention, the woven material can be applied first, and the drops of solder paste applied on the material before soldering.

According to other embodiments of the invention, there can be used, a conductive adhesive (typically a metal-containing paste requiring heat curing, such as silver-filled epoxy resin) or an anisotropic paste (typically requiring compression and heat curing) instead of solder paste, which can also be applied before or after the woven material. In such cases, it is also important that the insulating material should remain chemically inert and physically unaffected during the contacting step.

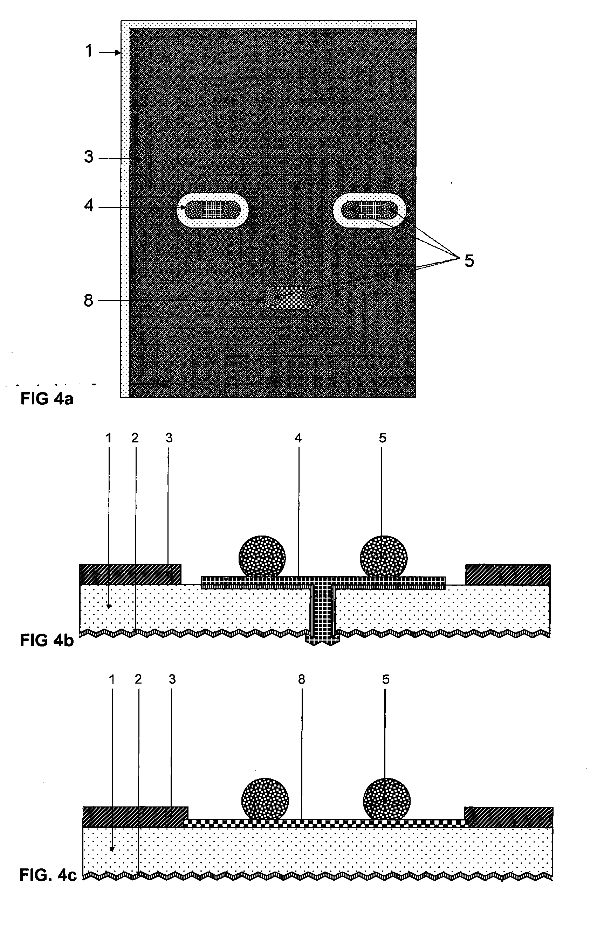

Fig 4a 4b and 4c show the same views as respectively Fig 3a 3b and 3c after application of two drops of paste on each contact point, according to an embodiment of the invention. The size and number of drops has to be adapted to the size and shape of the contact points.

There is then applied over the entire surface of the back side of the cell, a layer of hybrid woven material made of conductive wires interwoven with insulating wires using the Leno weaving pattern wherein the filling threads are selected from conductive wires and a combination of conductive wires and insulating threads, and the warp threads are insulating threads.

The conductive wires need to be surrounded by insulating wires so as not to be in contact with the surface on which the material is laid. Leno weave is most preferred (the way the warp and filling threads interlace with each other is called the weave). In the Leno weave, two (or more) warp yarns are twisted around each other, alternatively in the left and right hand direction, as they are interlaced with the filling (or weft) yarns; this secures a firm hold on the filling yarn and prevents them from slipping out of position. This weave is thus particularly favourable to creating a more open weave, a weave in which warp threads are further spaced apart, leaving larger interstices in the fabric.

According to a particularly preferred embodiment, the two yarns crossing each other can have different diameters, alternating from one set of yarns to the next.

In this description, thread is taken as a generic term for yarn (several filaments) or wire (one filament). Each filling thread could be a yarn or a wire but is preferably a wire, because there is no technical reason to use a conductive yarn for dc current. The warp threads are usually yarns.

The electrically insulating material must be resistant to the temperature required for soldering or otherwise making the connection and for the later lamination (encapsulation) step.

The preferred material forming the insulating layer is glass, because it combines all the desired properties: it is an inert material (already used in solar panels but for other purposes, thus known in the art to have the required long term resistance); it has excellent physical properties and will contribute to the dimensional stability of the cells; it has excellent electrical insulation properties; it has excellent chemical properties, being essentially inert (moisture-resistant, no outgassing) and fire-resistant; and it is relatively inexpensive.

It is not required to use another glass than the common "E" (electrical) type, having as typical composition 52-60 wt% silica, 16-25 wt% calcium oxide, 12-16 wt% alumina, 8-13 wt% boron oxide, 0-1 wt% sodium and potassium oxide, and 0-6 wt% magnesium oxide.

According to a preferred embodiment, the yarn is composed of continuous filaments (as represented by "C" in the description of woven glass fibre material). The average filament diameter is indicated in the art as a figure expressed in um; values of 4-10 can be used, values of 7-9 being preferred. The strand count is indicated in the art as a figure expressed in 100 yd/lb (1 yd = 0.9144 m; 1 lb = 0.454 kg); values of 25-50 are preferred.

The glass fibres can be used without finish. Leno weave is dimensionally stable thus requires no weave lock to be applied of the fibres to improve dimensional stability. It may however be desired to apply a black (or white) finish for aesthetic reasons, so that any material extending beyond a cell would have the same appearance as the black (or white) back sheet of the solar panels.

The preferred material forming the conductive wires is copper, as commonly used in electrical wires, usually covered with a thin layer of tin or other solder to prevent corrosion and, in case of soldering, to improve solderability.

The cross-section of the conductive wires is selected to balance the cost of copper with resistive losses to optimise the cost per Watt-peak; one objective could be that the cost per Watt-peak would be comparable to or lower than the cost per Watt-peak for a standard cell, still providing the aesthetical advantage of a back-contact cell; another objective could be to reduce resistive losses, so as to increase the output expressed in Watt-peak per m2.

The openings in the hybrid material should be small with respect to the size of the contact points and of the connectors, but large enough for the heated solder or conductive adhesive to flow into the woven material. This is obtained by using a normal weave, in which both warp threads and filling threads are visible, and easily checked with a simple and quick test; an open weave material makes it even easier for the heated solder or conductive adhesive to flow into the woven material.

Alignment of the conductive wires is required, the conductive wires being aligned with contact points of the same polarity, each contact point facing at least one conductive wire. The layer of hybrid woven material can also be applied on a panel comprising several cells when it is desired to connect these cells in parallel.

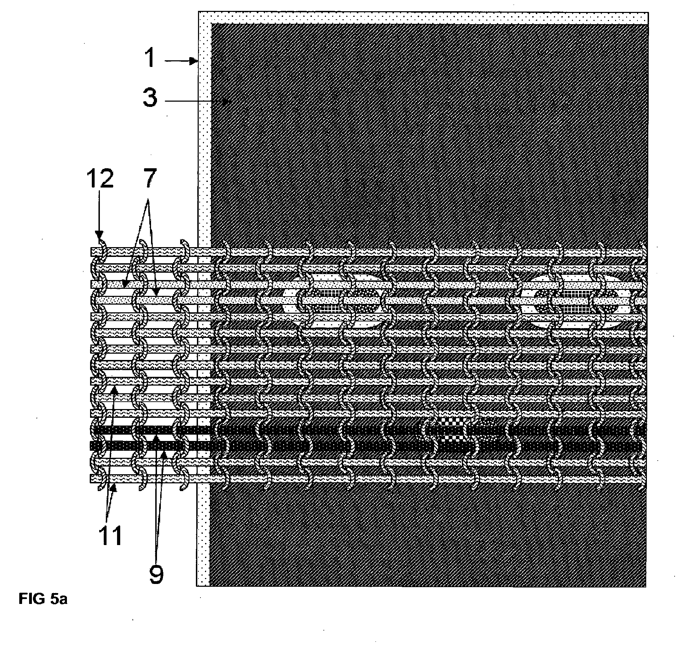

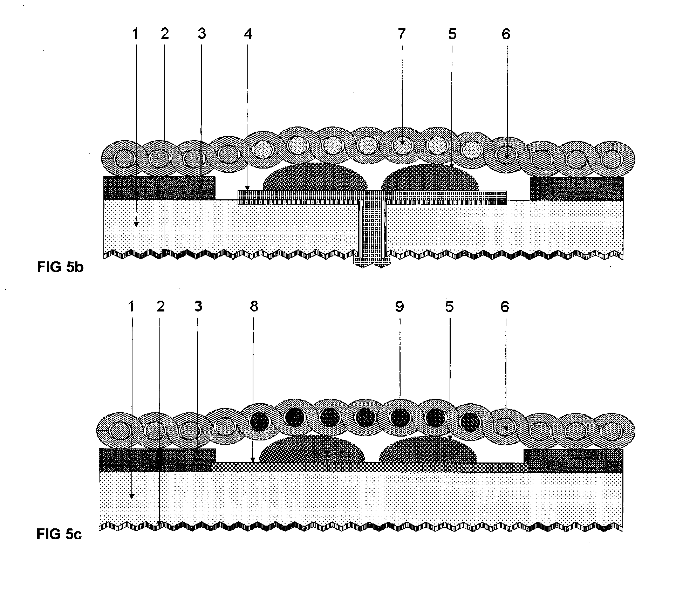

Fig 5a 5b and 5c show the same views as respectively Fig 4a 4b and 4c after laying a layer of hybrid Leno weave material over the backside of the cell. Fig 5b and 5c are cross-sections perpendicular to the filling (conductive) threads.

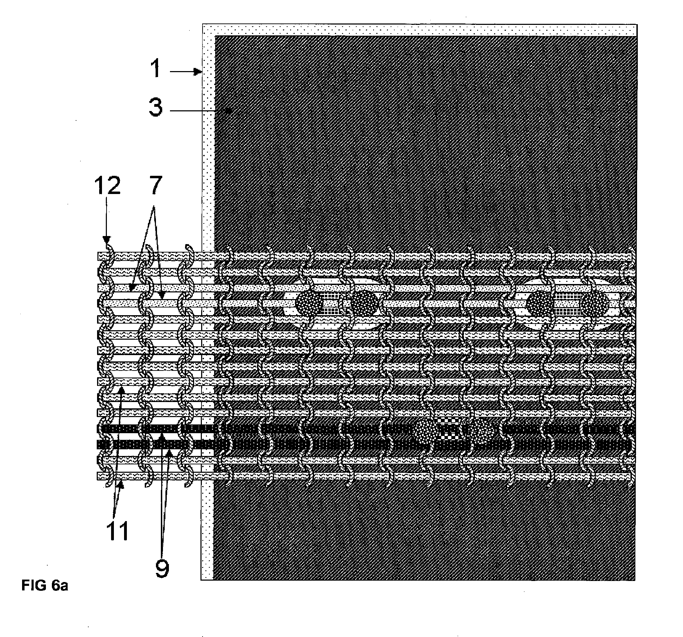

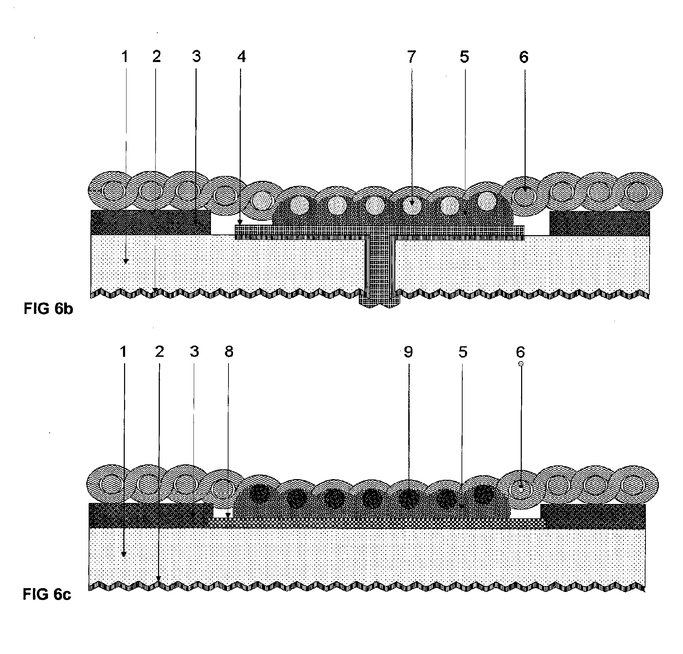

Fig 6a 6b and 6c show the same views as respectively Fig 5a 5b and 5c after finalising the electrical connection, whether by soldering (if solder paste is used) or heat curing (if a conductive adhesive or an anisotropic paste is used).

Referring to the use of solder paste, it can be seen that the solder when molten flowed through the woven material and now electrically connects the contact point to the conductive wires. On places where no solder paste has been applied and soldering step took place, the insulating warp threads will serve as an insulating material and as a spacer, avoiding shortcuts and undesired electrical connections. It is clear from the figures that the fabric has remained physically unaffected by the soldering process; in other words, it is the insulating warp threads that continue to keep the conductive wires spatially separated from the back of the cell.

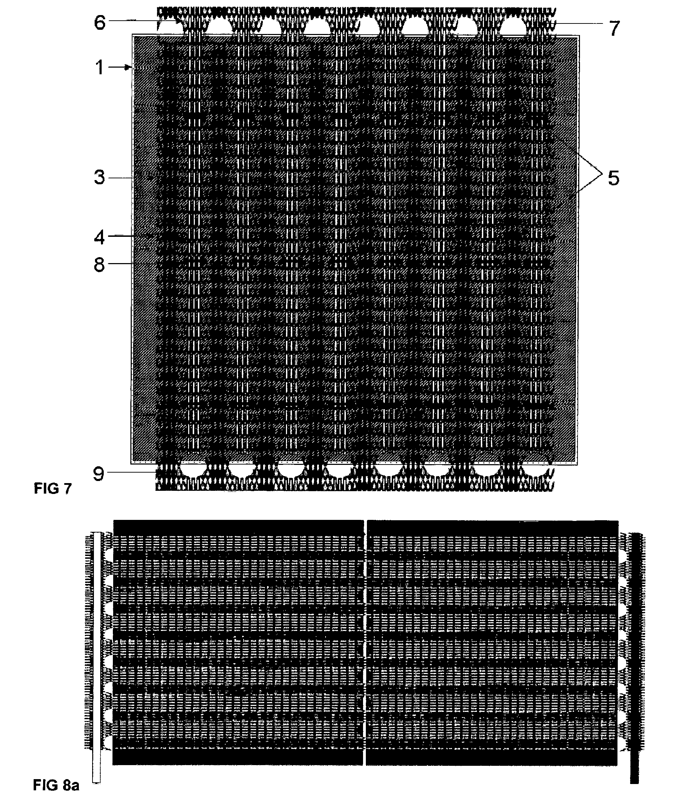

In another embodiment (shown in Fig.7), the connecting wires are oriented at 90° from their position on Fig 6a. In this embodiment, made using the same cell (represented on Fig 1), there are now 17 rows of contact points (9 to the front, 8 to the back) instead of 6 (3 to each of front and back), thus showing that more flexibility is available: for example, the total cross-section of conductive wires may be spread over a larger amount of wires.

In yet another embodiment, the hybrid woven material extends over more than one cell. In order to connect them in series, the connecting wires must be interrupted at appropriate locations between the cells (e.g. by punching a hole in the material at appropriate locations), the contact points of one polarity of each cell being connected to the contact points of the opposite polarity of the next cell (e.g. when using cells as shown in Fig 1, by turning the second cell 180° compared to the first one). Connecting two or more solar cells together creates a solar module, as shown on Fig 8a 8b and 8c.

At the end of the cell or series of cells, the current can be collected by any appropriate means. Using end ribbons and appropriately located interruptions of the connecting wires(e.g. holes), the current can be collected by making a serial connection of the cells.

According to an embodiment, shown in Fig 8a, the connectors are standard solderable connectors, preferably covered with a thin layer of solder to ensure optimal soldering, which as long known in the art may be provided with expansion bends so that the cells will not be subject to stress after the soldering step; the connectors are electrically connected to the conductive wires according to the present invention.

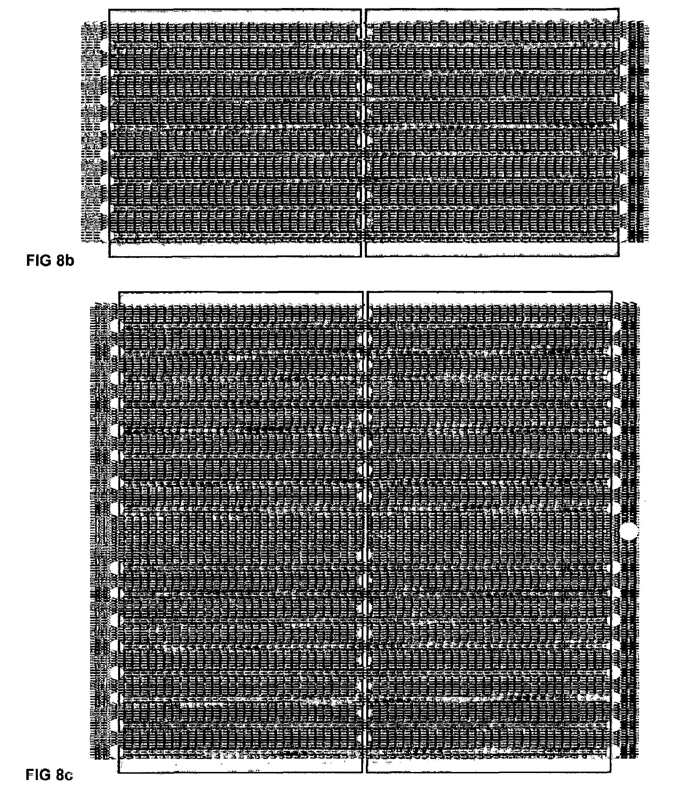

According to another embodiment, shown in Fig 8b, there are provided a few warp conductive yarns at each end, with electrical insulation being alternately provided between the warp conductive wires and the filling conductive wires (e.g. by punching holes in the material at appropriate locations).

Fig. 8c shows the connection between two strings, each consisting of 2 cells. The string connection is provided by using warp conductive wires, with punched holes at appropriate locations between the cells to interrupt the connecting wires as required.

During the later lamination of the cell into a solar module (panel) comprising several cells, the encapsulation material (typically EVA, silicone, thermoplastic polyolefin or other suitable encapsulation material known in the art) will embed the fabric, and the fabric will provide additional dimensional stability and reinforcement to the solar panel.

This invention allows more flexibility in the selection of the number of rows of contact points and the number of contact points per row, thus enabling more flexibility in the design of the back-contact cells, particularly of MWT cells.

Whilst the invention has been described with reference to preferred embodiments, it can also be used for soldering connectors in EWT or IBC type cells or generally any back-contact solar cell, wherein the connectors have to be electrically connected to areas of one polarity whilst being electrically insulated from the neighbouring areas of the opposite polarity.

### Example

A MWT back-contact cell can be prepared according to the preferred embodiment of the process described in WO 98/54763. Figure 1b shows the non-illuminated face of the 156 mm x 156 mm cell with six rows of contact points. The contact points have a rectangular shape with rounded ends, as shown: the contact points connected to the illuminated face are 2 mm wide and 6 mm long, surrounded by a 1 mm wide non-metallised area, whilst the contact points connected to the charged area of the non-illuminated face are 2.5 mm wide and 6 mm long. Starting from the top (as shown on Figure 11), the non-illuminated face is provided with a row of 9 contact points, one every 17 mm, connected to the illuminated face, then a row of 8 contact points connected to the charged area of the non-illuminated face, also every 17 mm, this arrangement being repeated a further two times.

On each contact point, there are deposited two 1.8 mm diameter drops of solder paste, said 1.8 mm diameter having been determined in a separate experiment to give a 0.9 mm diameter bump after heating. The solder paste is obtained from EFD under the name NC-D501: it consists of a NC (No Clean) flux basis containing Sn43 Pb43 Bi14 alloy powder of 45-75 um size. The solder paste is selected to be adapted to soldering to the alloy covering the connectors and to resist to the later step of lamination. The total weight of solder paste on the cell is 0.27 g after deposition or 0.23 g after drying.

The non-illuminated face is then covered with a layer of hybrid Leno weave material, an experimental material custom-prepared by Porcher Industries. It is a Leno weave material, with EC9 68 yarn, with finish 094 (black). The tinned copper wires are aligned perpendicularly to the rows of contact points.

The cell is heated to 150 °C. A solder tip at a temperature of 270°C is then applied on top of each contact point with light hand pressure to ensure good contact between the layers.

A drop of solder paste is deposited about 3mm before the end of the series of tinned copper wires, alternatively on each side. A 5 mm wide strip of plain weave glass fibre material is first laid over each line of drops, thus laid perpendicularly to the tinned copper wires. A connector consisting of a 100 um thick and 3 mm wide strip of copper covered with a 30 um layer of Sn solder is then laid over each strip. A solder tip at a temperature of 270°C is finally applied on top of each contact point, with light hand pressure to ensure good contact between the layers, before allowing the cell to cool down.

## Claims

1. Hybrid woven material for use in making solar cells or modules, made of conductive wires (10) interwoven with insulating wires (11, 12); **characterized by** a weaving pattern that the conductive wires (10) remain spatially separated by insulating threads (12) from a surface when the material is applied against said surface.

2. Material according to claim 1, wherein the weaving pattern is the Leno weaving pattern.

3. Material according to claim 1 or 2, wherein the filling threads (10, 11) are selected from conductive wires (10) and a combination of conductive wires (11) and insulating threads.

4. Material according to any one of the preceding claims, wherein the warp threads (12) are insulating threads.

5. Back-contact solar cell wherein the contact points (4, 8) to the two oppositely doped regions of the solar cells are placed on the non-illuminated surface of the solar cell, comprising connectors to collect the current from the contact points, **characterised in that** the connectors are conductive wires (10) interwoven with insulating wires (11, 12) in a hybrid woven material according to any one of claims 1 to 4, each conductive wire connecting contact points of the same polarity on the cell.

6. Assembly of at least two back-contact cells according to claim 5, wherein the hybrid woven material extends over more than one cell, the contact points of one polarity of each cell being connected to the contact points of the opposite polarity of the next cell, the connecting wires being interrupted at appropriate locations between the cells in order to connect them in series

7. Process for connecting ohmic contacts of a back-contact solar cell to external connectors, comprising the steps of:
- providing a solar cell wherein the contact points (4, 8) to the two oppositely doped regions are placed on its non-illuminated surface;
- providing a hybrid woven material according to any one of claims 1 to 4;
- laying a layer of the hybrid woven material over the non-illuminated surface of the solar cell, the conductive wires being aligned with contact points of the same polarity, each contact point facing at least one conductive wire (10) ;
- electrically connecting each contact point to the conductive wires facing it, thereby embedding the insulating wires (11, 12) physically separating the conductive wires from the contact point into the connection.

8. Use in back-contact solar cells or modules of a hybrid woven material according to any one of claims 1 to 4.

## Patentansprüche

1. Hybridgewebematerial zur Verwendung bei der Herstellung von Solarzellen oder -modulen, die aus leitenden Drähten (10) bestehen, die mit isolierenden Drähten (11, 12) verwebt sind, **gekennzeichnet durch** ein Webmuster derart, dass die leitenden Drähte (10) **durch** isolierende Fäden (12) räumlich von einer Oberfläche getrennt bleiben, wenn das Material auf die Oberfläche aufgebracht wird.

2. Material nach Anspruch 1, wobei das Webmuster das Leno-Webmuster (Dreherweben) ist.

3. Material nach Anspruch 1 oder 2, wobei die Füllfäden (10, 11) aus leitenden Drähten (10) und einer Kombination aus leitenden Drähten (10) und isolierenden Fäden (11) ausgewählt sind.

4. Material nach einem der vorhergehenden Ansprüche, wobei die Kettfäden (12) isolierende Fäden sind.

5. Rückkontakt-Solarzelle, bei der die Kontaktpunkte (4, 8) zu den zwei entgegengesetzt dotierten Bereichen der Solarzellen an der nicht beleuchteten Oberfläche der Solarzelle angeordnet sind und die Anschlüsse umfasst, um Strom von den Kontaktpunkten zu sammeln, **dadurch gekennzeichnet, dass** die Anschlüsse leitende Drähte (10) sind, die mit isolierenden Drähten (11, 12) in einem Hybridgewebematerial nach einem der Ansprüche 1 bis 4 verwebt sind, wobei jeder leitende Draht Kontaktpunkte der gleichen Polarität auf der Zelle anschließt.

6. Anordnung aus mindestens zwei Rückkontaktzellen nach Anspruch 5, wobei sich das Hybridgewebematerial über mehr als eine Zelle erstreckt, die Kontaktpunkte einer Polarität jeder Zelle an die Kontaktpunkte der entgegengesetzten Polarität der nächsten Zelle angeschlossen sind und die Anschlussdrähte an geeigneten Stellen zwischen den Zellen unterbrochen sind, um diese in Reihe zu schalten.

7. Verfahren zum Anschließen ohmscher Kontakte einer Rückkontakt-Solarzelle an externe Anschlüsse, folgende Schritte umfassend:
Bereitstellen einer Solarzelle, bei der die Kontaktpunkte (4,8) zu den zwei entgegengesetzt dotierten Bereichen an der nicht beleuchteten Oberfläche angeordnet sind,
Bereitstellen eines Hybridgewebematerials nach einem der Ansprüche 1 bis 4,
Legen einer Schicht des Hybridgewebematerials über die nicht beleuchtete Oberfläche der Solarzelle, wobei die leitenden Drähte an den Kontaktpunkten der gleichen Polarität ausgerichtet werden, wobei jeder Kontaktpunkt mindestens einem leitenden Draht (10) gegenüberliegt,
elektrisches Anschließen jedes Kontaktpunktes an die ihm gegenüberliegenden leitenden Drähte, wodurch die isolierenden Drähte (11, 12) eingebettet werden, was die leitenden Drähte physisch von den Kontaktpunkten in den Anschluss trennt.

8. Verwendung eines Hybridgewebematerials nach einem der Ansprüche 1 bis 4 in Rückkontakt-Solarzellen oder -modulen.

## Revendications

1. Matériau tissé hybride utilisé pour fabriquer des cellules ou des modules solaires, composé de fils conducteurs entrelacés avec des fils isolants, l'utilisation d'un tel motif de tissage faisant en sorte que les fils conducteurs restent spatialement séparés d'une surface, par des fils isolants, quand le matériau est appliqué sur ladite surface.

2. Matériau selon la revendication 1, dans lequel le motif de tissage est le motif de tissage Leno.

3. Matériau selon la revendication 1 ou 2, dans lequel les fils de remplissage sont sélectionnés à partir de fils conducteurs et d'une combinaison de fils conducteurs et de fils isolants.

4. Matériau selon l'une quelconque des revendications précédentes, dans lequel les fils de chaîne sont des fils isolants.

5. Cellule solaire à contact arrière dans laquelle les points de contact sur les deux régions - dopées de façon opposée - des cellules solaires sont placés sur la surface non éclairée de la cellule solaire, comprenant des connecteurs pour capter le courant provenant des points de contact,
**caractérisée en ce que** les connecteurs sont des fils conducteurs entrelacés avec des fils isolants dans un matériau tissé hybride selon l'une quelconque des revendications 1 à 4, chaque fil conducteur connectant des points de contact ayant la même polarité sur la cellule.

6. Ensemble d'au moins deux cellules à contact arrière selon la revendication 5, dans lequel le matériau tissé hybride s'étend sur plus d'une cellule, les points de contact d'une polarité de chaque cellule étant connectés aux points de contact de la polarité opposée de la cellule suivante, les fils de connexion étant interrompus au niveau d'emplacements appropriés situés entre les cellules pour les connecter en série.

7. Procédé pour connecter des contacts ohmiques d'une cellule solaire à contact arrière, aux connecteurs extérieurs, comprenant les étapes consistant :
- à fournir une cellule solaire dans laquelle les points de contact sur les deux régions dopées de façon opposée sont placés sur la surface non éclairée de ladite cellule solaire ;
- à fournir un matériau tissé hybride selon l'une quelconque des revendications 1 à 4 ;
- à appliquer une couche du matériau tissé hybride sur la surface non éclairée de la cellule solaire, les fils conducteurs étant alignés avec des points de contact ayant la même polarité, chaque point de contact faisant face à au moins un fil conducteur ;
- à connecter électriquement chaque point de contact aux fils conducteurs lui faisant face, enrobant ainsi les fils isolants séparant physiquement les fils conducteurs, du point de contact dans la connexion.

8. Utilisation, dans des cellules ou des modules solaires à contact arrière, d'un matériau tissé hybride selon l'une quelconque des revendications 1 à 4.
